# EUROPEAN PATENT APPLICATION

(11) **EP 2 282 356 A2**
(43) Date of publication of application: **09.02.2011**
(21) Application number: 10171074.7
(22) Date of filing: 28.07.2010
(51) Int. Cl.: H01L 35/30

(54) **Heat exchanger including thermoelectric module**

(30) Priority: 05.08.2009 JP 2009182502
(71) Applicant: Kabushiki Kaisha Toyota Jidoshokki, Kariya-shi, Aichi 448-8671 (JP)
(72) Inventor: Morisaku, Naoto, Kariya-shi Aichi 448-8671 (JP); Akiyama, Hirokuni, Kariya-shi Aichi 448-8671 (JP)
(74) Representative: TBK-Patent

(57) **Abstract**

A heat exchanger includes a thermoelectric module (11). A first fluid passage (13) is arranged at a heat dissipation side of the thermoelectric module (11) and a second fluid passage (15) is arranged at a heat absorption side of the thermoelectric module (11). The thermoelectric module (11) includes P type and N type thermoelectric semiconductor elements (16, 17). An electrical insulator (21) couples the P type and N type thermoelectric semiconductor elements (16, 17). Heat dissipation side electrodes (18) are exposed in the first fluid passage (13) and heat absorption side electrodes (19) are exposed in the second fluid passage (14). At least the heat dissipation side of the thermoelectric module (11) includes valleys and ridges with the heat dissipation side electrode (18) being free from projections.

## Description

### BACKGROUND OF THE INVENTION

The present invention relates to a heat exchanger, and more particularly, to a heat exchanger including a thermoelectric module (Peltier module) in which a plurality of P type thermoelectric semiconductor elements and a plurality of N type thermoelectric semiconductor elements are electrically connected in series by electrodes and thermally arranged in parallel.

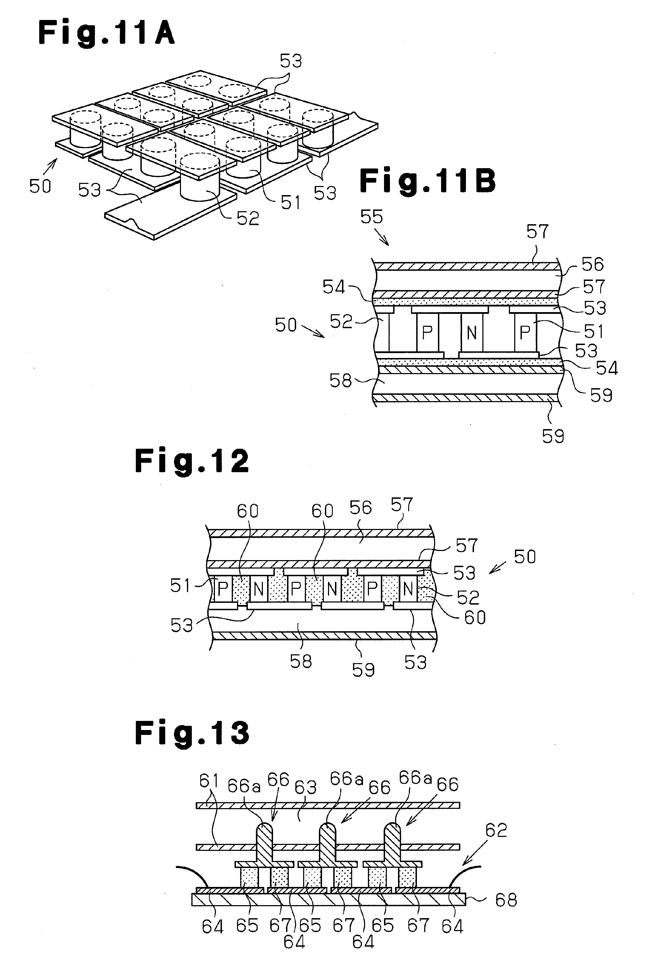

Fig. 11A shows the structure of a typical thermoelectric module 50 that allows for mutual conversion of heat energy and electrical energy. The thermoelectric module 50 includes a plurality of P type thermoelectric semiconductor elements 51 and a plurality of N type thermoelectric semiconductor elements 52. The P type thermoelectric semiconductor elements 51 and the N type thermoelectric semiconductor elements 52 are alternately arranged on a two dimensional plane and electrically connected in series by electrodes 53. When the thermoelectric module 50 is supplied with DC current, heat is absorbed at one of upper and lower heat exchanging surfaces of the thermoelectric module 50 and dissipated at the other one of the heat exchanging surfaces. Fig. 11B shows a heat exchanger 55 including the thermoelectric module 50. The upper and lower electrodes 53 are coupled to ceramic insulative plates 54. This forms a sandwiching structure in which the P type thermoelectric semiconductor elements 51, the N type thermoelectric semiconductor elements 52, and the electrodes 53 are held between the insulative plates 54. The heat exchanger 55 includes a fluid passage 57. A temperature-controlled fluid 56 flows through the fluid passage 57, which is formed at one heat exchanging side of the thermoelectric module 50. The heat exchanger 55 further includes a fluid passage 59. A temperature-controlling medium 58 (heating medium or cooling medium) for heating or cooling the temperature-controlled fluid 56 flows through the fluid passage 59, which is formed at the other heat exchanging side.

In the structure of the heat exchanger 55 shown in Fig. 11B, the insulative plates 54 and the inner wall surfaces of the fluid passages 57 and 59 are arranged between the electrodes 53 and the temperature-controlled fluid 56 or between the electrodes 53 and the temperature-controlling medium 58. This structure produces thermal resistance that lowers the efficiency of heat transfer. Further, the difference in the coefficient of thermal expansion between the insulative plates 54 and the P type thermoelectric semiconductor elements 51 and the difference in the coefficient of thermal expansion between the insulative plate 54 and the N type thermoelectric semiconductor elements 52 produces thermal stress applied to the coupled portions and the semiconductor elements. This lowers the durability of the coupled portions and the semiconductor elements.

A heat exchanger using a thermoelectric module that has satisfactory heat transfer efficiency and transfers heat with small heat variations has been proposed. This structure does not use the insulative plates 54, and the electrodes 53 on at least one of the heat exchanging surfaces of the thermoelectric module 50 are in direct contact with the fluid in the fluid passages 57 and 59 (for example, refer to Japanese Laid-Open Patent Publication No. 11-68173). In the thermoelectric module 50 of this heat exchanger, as shown in Fig. 12, an electrical insulator 60 is filled and solidified in gaps formed between the P type thermoelectric semiconductor elements 51 and the N type thermoelectric semiconductor elements 52. The electrical insulator 60 provides for insulation and increases the structural strength of the thermoelectric module 50. There is no passage wall between the lower fluid passage 59 and the thermoelectric module 50. The thermoelectric module 50 itself forms the passage wall of the fluid passage 59. Thus, the temperature-controlling medium 58 is in direct contact with the electrical insulator 60 and the electrodes 53. The publication describes another structure in which there is also no passage wall between the upper fluid passage 57 and the thermoelectric module 50.

To improve the heat dissipation efficiency, a thermoelectric conversion unit (heat exchanger) including heat dissipation side electrodes having heat dissipation portions exposed in a refrigerant passage has been proposed (Japanese Laid-Open Patent Publication No. 2000-286459). As shown in Fig. 13, the heat exchanger includes a refrigerant jacket 61 and a thermoelectric module 62 (thermoelectric conversion unit). A refrigerant passage 63 is formed in the refrigerant jacket 61. In the thermoelectric module 62, a heat absorption side electrode 64, an N type thermoelectric semiconductor element 65, a heat dissipation side electrode 66, and a P type thermoelectric semiconductor element 67 are electrically connected in this order to form a single unit. A plurality of such units (three units in the drawing) are connected in series.

The heat absorption side electrodes 64 are formed to be planar and coupled to an insulative substrate 68. End faces of an N type thermoelectric semiconductor element 65 and a P type thermoelectric semiconductor element 67 are each electrically coupled to each heat absorption side electrode 64. The heat dissipation side electrodes 66 each have an extension 66a formed on the surface opposite to the surface coupled to the corresponding N type thermoelectric semiconductor element 65 and P type thermoelectric semiconductor element 67. The extensions 66a, which are coated by insulative layers, are inserted into holes formed at predetermined intervals in the refrigerant jacket 61. This exposes the extensions 66a in the refrigerant passage 63. In addition to the heat dissipation side electrodes 66, the heat absorption side electrodes 64 may also have extensions, which are inserted into holes formed at predetermined intervals in the refrigerant jacket 61 and exposed in a refrigerant passage.

In the heat exchanger of Japanese Laid-Open Patent Publication No. 11-68173, at least one of the heat transfer sides of the thermoelectric module 50 does not have the insulative plate 54. Further, the electrodes 53 are in contact with the fluids (temperature-controlled fluid 56 or temperature-controlling medium 58) in the fluid passages 57 and 59. This increases the heat transfer efficiency in comparison to a structure including the insulative plate 54. However, the heat exchange surface (heat transfer surface) that comes into contact with fluid is substantially planar and only includes shallow recesses between the electrodes 53. This forms a boundary layer when fluid flows in parallel with the heat exchange surface and greatly affects the heat exchange capacity.

In the thermoelectric conversion unit of Japanese Laid-Open Patent Publication No. 2000-286459, the extensions 66a of the heat dissipation side electrodes 66 are exposed in the refrigerant passage 63. Thus, the extensions 66a agitate the refrigerant flowing through the refrigerant passage 63. The effect of the turbulent flow increases the heat dissipating efficiency in comparison with the structure of Japanese Laid-Open Patent Publication No. 11-68173 of which the electrodes do not include such extensions. However, in the structure of Japanese Laid-Open Patent Publication No. 2000-286459, the number of holes formed in the refrigerant jacket 61 must be the same as the number of the heat dissipation side electrodes 66, and the holes receiving the extensions 66a must be sealed. This increases the burden on manufacturing and raises the manufacturing cost. Further, depending on the state of the seal, the force of the refrigerant applied to the extensions 66a may act on the coupled portions between the heat dissipation side electrodes 66 and the N type thermoelectric semiconductor elements 65 and on the coupled portions between the heat dissipation side electrodes 66 and the P type thermoelectric semiconductor elements 67. This lowers durability.

### SUMMARY OF THE INVENTION

It is an object of the present invention to provide a heat exchanger that performs heat exchange efficiently and includes a plurality of P type thermoelectric semiconductor elements and a plurality of N type thermoelectric semiconductor elements that are electrically connected in series and thermally arranged in parallel.

One aspect of the present invention is a heat exchanger including a thermoelectric module. Heat exchange is performed between a first fluid flowing through a first fluid passage arranged at a heat dissipation side of the thermoelectric module and a second fluid flowing through a second fluid passage arranged at a heat absorption side of the thermoelectric module. The thermoelectric module includes a plurality of P type thermoelectric semiconductor elements and a plurality of N type thermoelectric semiconductor elements that are thermally arranged in parallel. Heat dissipation side electrodes formed by planar plates and heat absorption side electrodes formed by planar plates electrically connect in series the P type thermoelectric semiconductor elements and the N type thermoelectric semiconductor elements. An electrical insulator couples the P type thermoelectric semiconductor elements and the N type thermoelectric semiconductor elements so as to impede fluid movement between the first fluid passage and the second fluid passage. The heat dissipation side electrodes are exposed in the first fluid passage and the heat absorption side electrodes are exposed in the second fluid passage. At least the heat dissipation side of the thermoelectric module includes valleys and ridges with the heat dissipation side electrodes being free from projections.

Other aspects and advantages of the present invention will become apparent from the following description, taken in conjunction with the accompanying drawings, illustrating by way of example the principles of the invention.

### BRIEF DESCRIPTION OF THE DRAWINGS

The invention, together with objects and advantages thereof, may best be understood by reference to the following description of the presently preferred embodiments together with the accompanying drawings in which:
Fig. 1 is a schematic cross-sectional view showing a heat exchanger according to a first embodiment of the present invention;
Fig. 2 is a schematic perspective view showing a thermoelectric module of Fig. 1 in a state in which an electrical insulator is partially removed from the thermoelectric module;
Fig. 3A is a plan view showing a thermoelectric module of Fig. 1 in a state in which electrodes are removed from the thermoelectric module;
Fig. 3B is a cross-sectional diagram taken along line 3B-3B in Fig. 3A;
Fig. 4 is a schematic cross-sectional view showing a state in which thermoelectric semiconductor elements are arranged in a lower mold;
Fig. 5 is a schematic cross-sectional diagram showing a state in which resin is filled in a mold to form the electrical insulator;
Fig. 6 is a schematic cross-sectional view showing a heat exchanger according to a second embodiment of the present invention;
Fig. 7 is a schematic perspective view showing a thermoelectric module of Fig. 6 in a state in which an electrical insulator is partially removed from the thermoelectric module;
Fig. 8A is a schematic cross-sectional view showing a heat exchanger according to a third embodiment of the present invention;
Fig. 8B is a schematic perspective view showing a thermoelectric module of Fig. 8A in a state in which an electrical insulator is partially removed from the thermoelectric module;
Fig. 9A is a schematic cross-sectional view showing a heat exchanger according to a fourth embodiment of the present invention;
Fig. 9B is an enlarged cross-sectional view showing part of the thermoelectric module of Fig. 9A;
Fig. 9C is a plan view showing the thermoelectric module of Fig. 9A;
Figs. 10A and 10B are schematic perspective views showing projections in a further embodiment;
Fig. 11A is a schematic diagram showing a prior art thermoelectric module;
Fig. 11B is a schematic cross-sectional diagram showing a heat exchanger using the thermoelectric module of Fig. 11A;
Fig. 12 is a schematic cross-sectional diagram showing another prior art heat exchanger; and
Fig. 13 is a schematic cross-sectional diagram showing a further prior art heat exchanger.

### DETAILED DESCRIPTION OF THE PREFERRED EMBODIMENTS

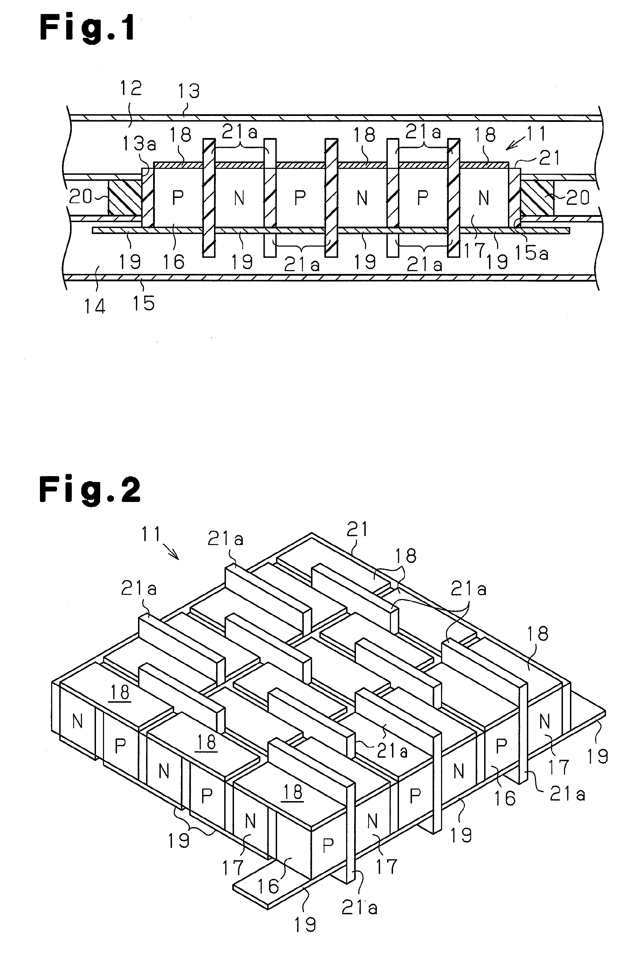

A first embodiment of the present invention will now be discussed with reference to Figs. 1 to 5.

Referring to Fig. 1, a heat exchanger includes a thermoelectric module 11. A first fluid 12 flows through a first fluid passage 13, which is located at a heat dissipation side (upper side as viewed in Fig. 1) of the thermoelectric module 11. A second fluid 14 flows through a second fluid passage 15, which is located at a heat absorption side (lower side as viewed in Fig. 1) of the thermoelectric module 11.

The thermoelectric module 11 includes a plurality of P type thermoelectric semiconductor elements 16 and a plurality of N type thermoelectric semiconductor elements 17. The P type thermoelectric semiconductor elements 16 and the N type thermoelectric semiconductor elements 17 are electrically connected in series by electrodes and thermally arranged in parallel. The phrase "thermally arranged in parallel" refers to a state in which the P type thermoelectric semiconductor elements 16 and N type thermoelectric semiconductor elements 17 have heat dissipation side surfaces that are all arranged on one side of the thermoelectric module 11 and heat absorption side surfaces that are all arranged on the other side of the thermoelectric module 11.

The first fluid passage 13 and the second fluid passage 15 are formed to be flat at least at portions that receive the thermoelectric module 11. Openings 13a and 15a, which face toward each other, are respectively formed in the first fluid passage 13 and the second fluid passage 15 to receive the thermoelectric module 11. The thermoelectric module 11 includes heat dissipation side electrodes 18 and heat absorption side electrodes 19. In a state in which the heat dissipation side electrodes 18 are exposed in the first fluid passage 13 and the heat absorption side electrodes 19 are exposed in the second fluid passage 15, the thermoelectric module 11 is arranged between the first fluid passage 13 and second fluid passage 15, which are spaced from each other by spacers 20. In the thermoelectric module 11, an electrical insulator 21, which is formed from a polymeric material, couples the P type thermoelectric semiconductor elements 16 and the N type thermoelectric semiconductor elements 17. This impedes the movement of fluid between the first fluid passage 13 and the second fluid passage 15. A thermosetting resin, a thermoplastic resin, or rubber may be used as the polymeric material. However, the preferable material for the electrical insulator 21 is thermosetting resin since thermosetting resin functions to increase the structural strength of the thermoelectric module 11 in addition to insulating the P type thermoelectric semiconductor elements 16 from the N type thermoelectric semiconductor elements 17.

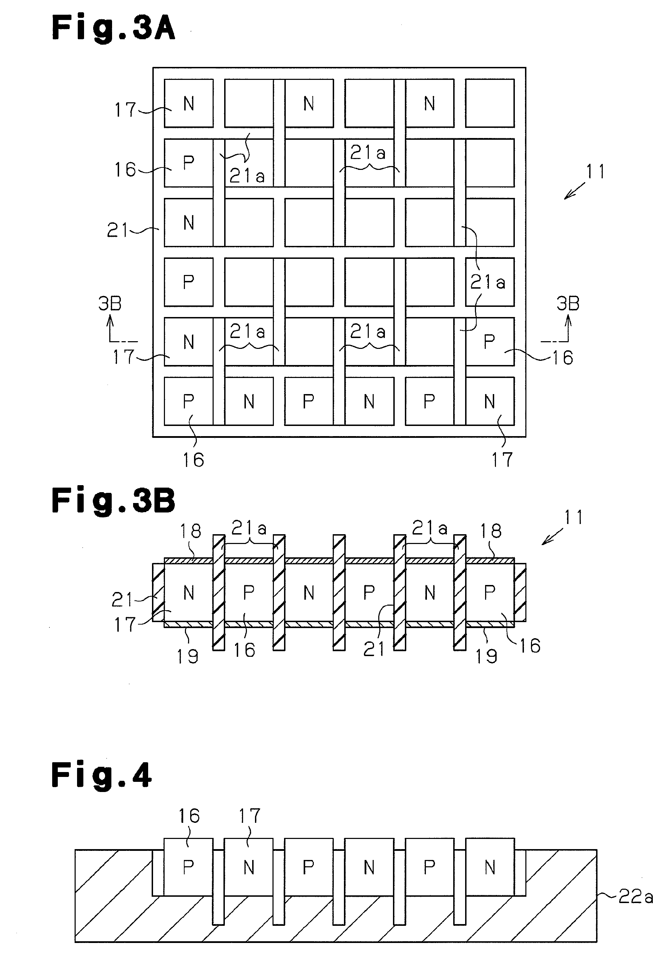

As shown in Fig. 3A, the P type thermoelectric semiconductor elements 16 and the N type thermoelectric semiconductor elements 17 are arranged in a plurality of lines so as to form a matrix array in which the P type thermoelectric semiconductor elements 16 are arranged adjacent to the N type thermoelectric semiconductor elements 17. The P type thermoelectric semiconductor elements 16 and N type thermoelectric semiconductor elements 17 are each formed to have the shape of a square pillar and each have metalized surfaces that are coupled to the electrodes 18 and 19. For example, the P type thermoelectric semiconductor elements 16 and N type thermoelectric semiconductor elements 17 may be soldered and electrically coupled to the electrodes 18 and 19. The electrodes 18 and 19 are each formed by a metal planar plate having a length allowing for the coupling of one set of a P type thermoelectric semiconductor element 16 and an N type thermoelectric semiconductor element 17. Further, the electrodes 18 and 19 each have an electrode surface, which is free from projections and which forms a main heat exchange surface of the thermoelectric module 11.

The electrical insulator 21 includes a plurality of projections 21a, which are formed in parts of the heat dissipation side and heat absorption side of the thermoelectric module 11. The projections 21a each project further from the electrodes 18 and 19 into the first fluid passage 13 or second fluid passage 15. In other words, the heat dissipation side and heat absorption side of the thermoelectric module 11 include valleys and ridges with the electrodes 18 and 19 being free from projections. As shown in Figs. 2 and 3(a), the projections 21a formed at the heat dissipation side have the shape of a parallelepiped, which extends in a direction perpendicular to the direction the first fluid 12 flows in the first fluid passage 13. The projections 21a are arranged in a zigzagged manner. The projections 21a formed at the heat absorption side are arranged in the same manner.

The electrodes 18 arranged at the heat dissipation side are all connected to the P type thermoelectric semiconductor elements 16 and N type thermoelectric semiconductor elements 17, which extend parallel to the direction the projections 21a extend. Thus, the electrodes 18 do not interfere with the projections 21a regardless of the locations of the projections 21a. The phrase "the direction the projections 21a extend" refer to the widthwise direction of the fluid passage 15, that is, the direction perpendicular to the direction fluid flows. Among the electrodes 19 arranged at the heat absorption side, the electrodes 19 at the two sides of the thermoelectric module 11 with respect to the direction the projections 21a extend are arranged in a direction perpendicular to the direction the projections 21a extend, that is, in the flow direction of the fluid 14. Thus, the projections 21a are formed at positions that do not interfere with the electrodes 19.

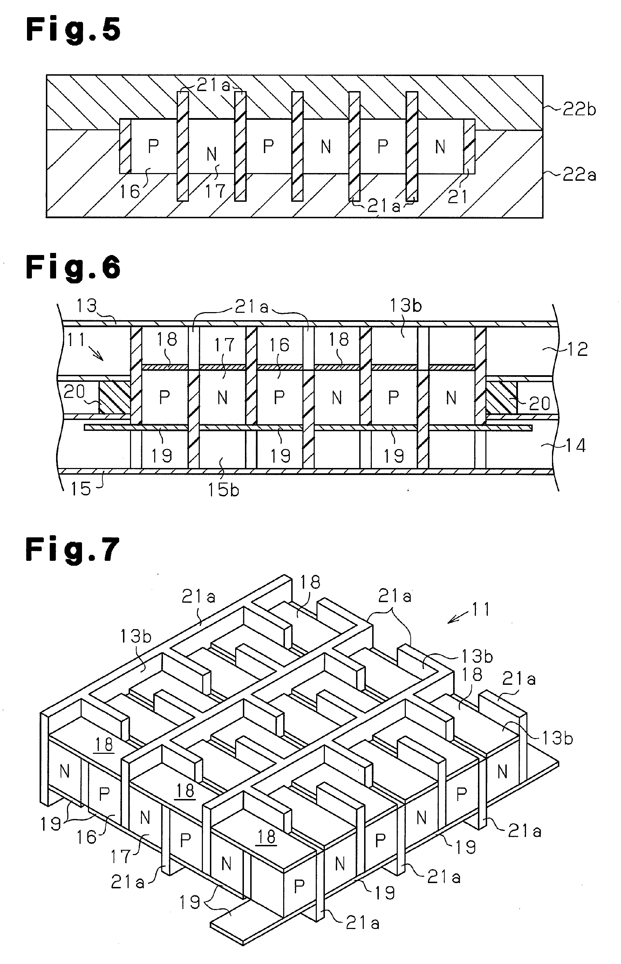

The manufacturing of the thermoelectric module 11 will now be described. Insert molding is performed to form a thermoelectric element unit that couples the P type thermoelectric semiconductor elements 16 and N type thermoelectric semiconductor elements 17 to the electrical insulator 21. Then, the end faces of the P type thermoelectric semiconductor elements 16 and N type thermoelectric semiconductor elements 17 are soldered to the electrodes 18 and 19 to manufacture the thermoelectric module 11. When performing insert molding, as shown in Fig. 4, the P type thermoelectric semiconductor elements 16 and the N type thermoelectric semiconductor elements 17 are positioned and arranged in a lower mold 22a. Then, as shown in Fig. 5, after an upper mold 22b closes the lower mold 22a, an unhardened thermosetting resin is charged into the lower and upper molds 22a and 22b and heated for hardening. This forms the thermoelectric element unit. The positioning of the P type thermoelectric semiconductor elements 16 and the N type thermoelectric semiconductor elements 17 is performed by arranging one end of each of the P type thermoelectric semiconductor elements 16 and the N type thermoelectric semiconductor elements 17 in shallow recesses formed in the lower mold 22a.

The operation of the heat exchanger will now be described. The heat exchanger is used by applying DC voltage to the electrodes 18 and 19 so that the side of the thermoelectric module 11 facing toward the first fluid passage 13 serves as the heat dissipation side and the side facing toward the second fluid passage 15 serves as the heat absorption side. Further, the first fluid 12 and the second fluid 14 flow in the same direction in the first fluid passage 13 and the second fluid passage 15, for example, from the left toward the right as viewed in Fig. 1. The first fluid 12 circulates through a path that includes a cooling fan (not shown).

When the thermoelectric module 11 is activated, the heat absorption side electrodes 19 absorb heat from the second fluid 14, and the heat dissipation side electrodes 18 dissipate heat to the first fluid 12. That is, direct heat transfer is performed between the electrodes 19 and the second fluid 14, and direct heat transfer is performed between the electrodes 18 and the first fluid 12. When fluid travels in a laminar flow, laminar flow boundary layers are produced at the surfaces of the heat dissipation side electrode 18 and the heat absorption side electrodes 19 that serve as heat exchange surfaces. An increase in the influence of the boundary layer would decrease the heat exchange capacity. However, the thermoelectric module 11 includes the projections 21a at the heat dissipation side and heat absorption side so as to form valleys and ridges. Thus, turbulent flows are produced in the first fluid 12 flowing through the first fluid passage 13 and the second fluid 14 flowing through the second fluid passage 15 at portions corresponding to the thermoelectric module 11. The turbulent flows function to reduce the influence of the boundary layer at the heat exchange surface so that heat exchange is efficiently performed at the heat dissipation side and heat absorption side.

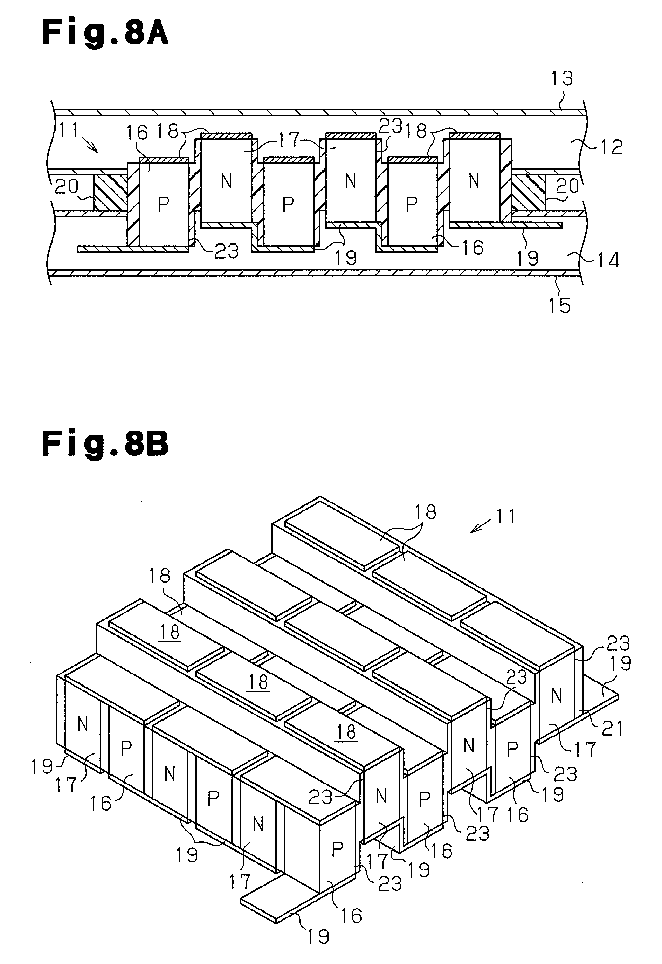

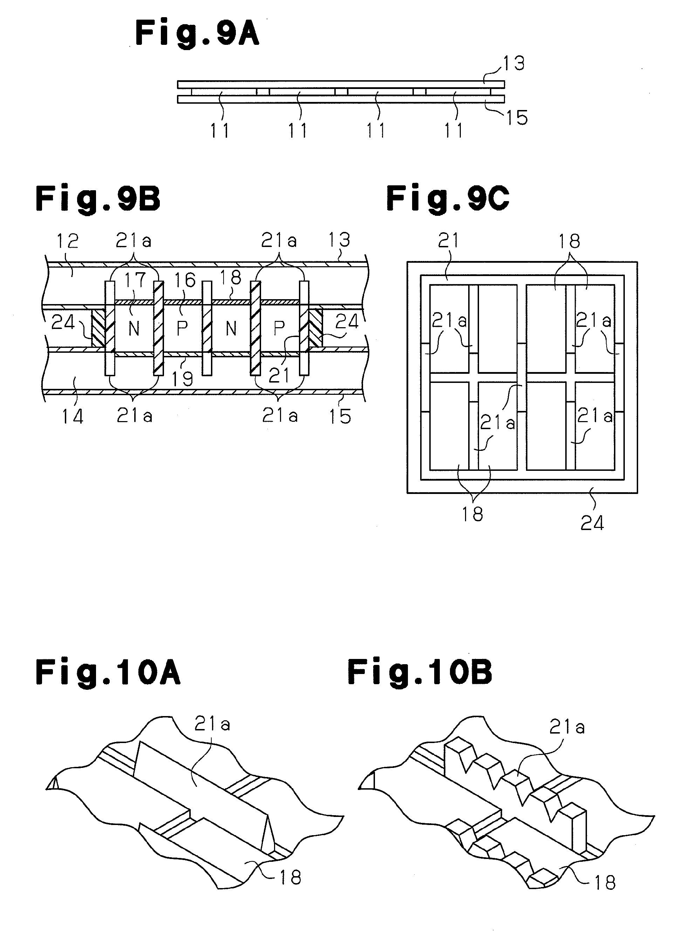

The first embodiment has the advantages described below.
(1) The heat dissipation side electrodes 18 and the heat absorption side electrodes 19 are respectively exposed in the first fluid passage 13 and the second fluid passage 15. Thus, the electrodes 18 and 19 are in direct contact with fluid (i.e., the first fluid 12 or the second fluid 14), and heat exchange is performed efficiently.
(2) The electrical insulator 21, which is formed from a polymeric material, couples the P type thermoelectric semiconductor elements 16 and the N type thermoelectric semiconductor elements 17. This impedes the movement of fluid between the first fluid passage 13 and the second fluid passage 15. The electrodes 18 and 19 are formed by planar plates, and the heat dissipation side and heat absorption side of the thermoelectric module 11 include valleys and ridges. Accordingly, the turbulent flow produced by the flow of fluid functions to reduce the influence of a boundary layer at the heat exchange surface so that heat exchange is efficiently performed at the heat dissipation side and heat absorption side. Thus, the heat exchanger efficiently performs heat exchange.
(3) The valleys and ridges at the heat dissipation side of the thermoelectric module 11 are formed by the projections 21a, which project from parts of the electrical insulator 21. The projections 21a project further from the electrodes 18 into the first fluid passage 13. The valleys and ridges at the heat absorption side of the thermoelectric module 11 are formed by the projections 21a, which project from parts of the electrical insulator 21. The projections 21a project further from the electrodes 19 into the second fluid passage 15. In this manner, valleys and ridges are formed in the heat dissipation side and heat absorption side without forming projections (extensions) on the electrodes 18 and 19. This simplifies the structure of the electrodes 18 and 19, which, in turn, simplifies the structure of the heat exchanger. Further, unlike when forming projections on the electrodes 18 and 19, the portions at which the electrodes 18 and 19 are coupled to the P type thermoelectric semiconductor elements 16 and the N type thermoelectric semiconductor elements 17 are free from the force of fluid that is applied to the projections. This prevents the durability of such coupled portions from being lowered, which, in turn, prevents the durability of the heat exchanger from being lowered. Moreover, in comparison with a structure that forms projections on electrodes, the manufacturing costs may be reduced.
(4) When using a mold to form the thermoelectric element unit by coupling the P type thermoelectric semiconductor elements 16 and the N type thermoelectric semiconductor elements 17 with the electrical insulator 21 while ensuring electric insulation, the portions that become the projections 21a are elongated from the other portions of the electrical insulator 21. This facilitates manufacturing in comparison to a structure that couples the projections 21a, or extensions, in a subsequent process.
(5) The electrodes 18 and 19 are formed by metal planar plates. Further, the connection positions of the electrodes 18 and 19 and the formation positions of the projections 21a are set so that interference does not occur between the electrodes 18 and 19 and the projections 21a.
   This simplifies the structures and formation of the electrodes 18 and 19.
   A second embodiment will now be discussed with reference to Figs. 6 and 7. This embodiment differs from the first embodiment in the shape of the projections 21a, which form the valleys and ridges in the heat dissipation side and heat absorption side of the thermoelectric module 11. To avoid redundancy, like or same reference numerals are given to those components that are basically the same as the corresponding components of the first embodiment. Such components will now be described in detail.
   As shown in Fig. 6, the projections 21a are formed to be in contact with the inner wall surface of the first fluid passage 13 and the second fluid passage 15. As shown in Fig. 7, the heat dissipation side projections 21a are projected to form a plurality of (three in this embodiment) flow paths 13b in the first fluid passage 13. The arrangement of the heat dissipation side electrodes 18 and the heat absorption side electrodes 19 is the same as the first embodiment. Thus, the heat absorption side projections 21a are projected to form a plurality of (two in this embodiment) flow paths 15b in the second fluid passage 15 so that the projections 21a do not interfere with the electrodes 19. Each flow path 15b is 1.5 times longer than each flow path 13b.
   In the heat exchanger of this embodiment, as the first fluid 12 that flows through the first fluid passage 13 passes through the portion corresponding to the thermoelectric module 11, the first fluid 12 is divided into three when entering the three flow paths 13b. Each flow path 13b is formed to meander and does not extend straight. Thus, the first fluid 12 produces a turbulent flow in each flow path 13b. Further, the second fluid 14 that flows through the second fluid passage 15 is divided into two when entering the two flow paths 15b. The second fluid 14 produces a turbulent flow in each flow path 15b. Further, whenever the second fluid 14 meanders back and forth in the flow path 15b, the second fluid 14 travels over a distance that is 1.5 times longer than the meandering distance of the flow paths 13b. As a result, the turbulent flow functions to reduce the influence of a boundary layer at the heat exchange surface, and heat exchange is efficiently performed at the heat dissipation side and heat absorption side.
   Accordingly, in addition to advantages (1) to (5) of the first embodiment, the second embodiment has the advantages described below.
(6) The first fluid 12 in the first fluid passage 13 and the second fluid 14 in the second fluid passage 15 flow along the flow paths 13b and 15b, which are formed by part of the electrical insulator 21. This facilitates calculation of the heat exchange efficiency for each of the electrodes 18 and 19.
(7) The thermoelectric module 11 is supported between the first fluid passage 13 and the second fluid passage 15 in a state in which the projections 21a are in contact with the inner wall surfaces of the first and second fluid passages 13 and 15. Thus, the projections 21a have distal ends that abut against the inner wall surface of the first fluid passage 13 and the inner wall surface of the second fluid passage 15. This allows for elimination of the spacer 20.
   A third embodiment will now be discussed with reference to Figs. 8A and 8B. This embodiment differs from the first embodiment in that the P type thermoelectric semiconductor elements 16 and the N type thermoelectric semiconductor elements 17 have end faces that are not arranged along the same plane. To avoid redundancy, like or same reference numerals are given to those components that are basically the same as the corresponding components of the first embodiment. Such components will now be described in detail.
   As shown in Figs. 8A and 8B, the P type thermoelectric semiconductor elements 16 and the N type thermoelectric semiconductor elements 17 are all formed to have the same size. However, the P type thermoelectric semiconductor elements 16 and the N type thermoelectric semiconductor elements 17 have end faces arranged in rows, the locations of which are alternately varied. In this state, the electrical insulator 21 couples the P type thermoelectric semiconductor elements 16 and the N type thermoelectric semiconductor elements 17. Accordingly, the thermoelectric module 11 in its entirety has valleys and ridges formed in both of the heat dissipation and heat absorption sides. Further, as shown in Fig. 8A, the thermoelectric module 11 is arranged between the first fluid passage 13 and the second fluid passage 15 in a state in which projections 23 extend in a direction perpendicular to the direction the first fluid 12 and second fluid 14 flow (from the left toward the right in Fig. 8A). The electrodes 18 connected to the P type thermoelectric semiconductor elements 16 and the N type thermoelectric semiconductor elements 17 at the heat dissipation side of the thermoelectric module 11 all extend parallel to the extending direction the projections 23. Thus, the electrodes 18 are formed to be planar. However, among the electrodes 19 coupled to the P type thermoelectric semiconductor elements 16 and the N type thermoelectric semiconductor elements 17 at the heat absorption side, the electrodes 19 located at the two sides of the thermoelectric module 11 with respect to the direction the projections 23 extend are each connected to a P type thermoelectric semiconductor element 16 that serves as a projection 23 and an N type thermoelectric semiconductor element 17 that does not serve as one. Thus, such an electrode 19 is bent into the shape of a crank to allow for the connection of the electrode 19.
   In this embodiment, valleys and ridges are also formed at portions in the heat dissipation side and heat absorption side of the thermoelectric module 11. Thus, turbulent flows are produced in the first fluid 12, which flows through the first fluid passage 13, and the second fluid 14, which flows through the second fluid passage 15, at portions corresponding to the thermoelectric module 11. The electrical insulator 21 couples the P type thermoelectric semiconductor elements 16 and the N type thermoelectric semiconductor elements 17 by performing insert molding with a mold having a cavity shaped differently from that of the first embodiment. Further, the electrodes 19 that are bent into the shape of a crank are easily manufactured by pressing a metal plate.
   Accordingly, in addition to advantages (1) and (2) of the first embodiment, this embodiment has the advantages described below.
(8) The valleys and ridges at the heat dissipation side of the thermoelectric module 11 are formed by coupling the P type thermoelectric semiconductor elements 16 and the N type thermoelectric semiconductor elements 17 with the electrical insulator 21 so that their end faces are arranged on different planes. Accordingly, the thermoelectric module 11 is easily manufactured by varying the locations of the P type thermoelectric semiconductor elements 16 and N type thermoelectric semiconductor elements 17 that have the same size and using the electrodes 19 that are formed by bending planar plates into a crank shape.
(9) The projections 23 are formed to extend entirely in the widthwise direction of the first fluid passage 13 and the second fluid passage 15 (i.e., the direction perpendicular to the direction in which fluid flows). Thus, there is a tendency for a turbulent flow to be easily produced along the entire heat exchange surface.
   A fourth embodiment will now be discussed with reference to Figs. 9A to 9C. This embodiment differs from each of the embodiments discussed above in that there are a plurality of thermoelectric modules. To avoid redundancy, like or same reference numerals are given to those components that are basically the same as the corresponding components of the first embodiment. Such components will now be described in detail.
   As shown in Fig. 9A, a heat exchanger includes a plurality of (four in this embodiment) thermoelectric modules 11 arranged between the first fluid passage 13 and the second fluid passage 15. In the embodiments discussed above, each thermoelectric module 11 includes a total of thirty-six P type thermoelectric semiconductor elements 16 and N type thermoelectric semiconductor elements 17. In this embodiment, each thermoelectric module 11 includes a total of sixteen P type thermoelectric semiconductor elements 16 and N type thermoelectric semiconductor elements 17. Thus, each thermoelectric module 11 includes less semiconductor elements than that of the first embodiment. However, the total number of the P type thermoelectric semiconductor elements 16 and N type thermoelectric semiconductor elements 17 in the four thermoelectric modules 11 is sixty-four. Thus, the total number of the semiconductor elements is greater than that of the first embodiment.
   As shown in Figs. 9B and 9C, a packing 24 is formed integrally with the periphery of each thermoelectric module 11. Further, as shown in Fig. 9B, the packing 24 holds the corresponding thermoelectric module 11 between the first fluid passage 13 and the second fluid passage 15. Projections 21a projecting into the first fluid passage 13 and the second fluid passage 15 are formed at the heat dissipation side and heat absorption side of each thermoelectric module 11. The thermoelectric modules 11 are connected in series by electrode terminals (not shown). Further, the thermoelectric modules 11 are all simultaneously supplied with the same current.
   In addition to advantages (1) to (5) of the first embodiment, this embodiment has the advantages described below.
(10) Each thermoelectric module 11 is independently attached by the corresponding packing 24 to the first fluid passage 13 and the second fluid passage 15 to form the entire heat exchanger. When the heat exchanger requires a large number of the P type thermoelectric semiconductor elements 16 and the N type thermoelectric semiconductor elements 17, the heat exchanger may increase the number of thermoelectric modules 11 accordingly, with each thermoelectric module 11 having a relatively small number of the P type thermoelectric semiconductor elements 16 and the N type thermoelectric semiconductor elements 17. This lowers the manufacturing cost of the thermoelectric module 11, which, in turn, lowers the manufacturing cost of the heat exchanger. Further, when one of the thermoelectric modules 11 becomes defective, only the defective thermoelectric module 11 needs to be replaced. This facilitates maintenance. When the heat exchanger fails to function normally, the defective thermoelectric module 11 may be located by detecting the voltage or current between the terminals of each thermoelectric module 11.

It should be apparent to those skilled in the art that the present invention may be embodied in many other specific forms without departing from the spirit or scope of the invention. Particularly, it should be understood that the present invention may be embodied in the following forms.

The shape of the projections 21a is not limited to a parallelepiped and may be a triangular solid as shown in Fig. 10A or saw-toothed as shown in Fig. 10B. Further, the length of the projections 21a may be varied. Alternatively, projections 21a of different shapes and lengths may be used in combination. The shapes, lengths, and the like of the projections 21a that allow for efficient heat exchange vary in accordance with the physical properties (e.g., viscosity) or flow velocity of the first fluid 12 and second fluid 14. It is thus preferable that experiments be conducted to obtain the shape, length, and the like that allows for a suitable turbulent flow to be easily produced when setting the shape, length, and location of the projections 21a.

The shape and length of the first fluid passage 13 and the second fluid passage 15 varies in accordance with the amount of heat generated by the thermoelectric module 11 and the physical properties (e.g., viscosity) and flow velocity of the refrigerant. It is thus preferable that experiments be conducted to obtain the shape, length, and the like that allows for a suitable turbulent flow to be easily produced when setting the shape, length, and location of the first and second fluid passages 13 and 15.

The thermoelectric module 11 is not limited to a structure in which the valleys and ridges are arranged on both of the heat dissipation side and the heat absorption side. It is only required that the valleys and ridges be arranged on at least the heat dissipation side. The amount of heat generated at the heat dissipation side is approximately four times greater than the heat absorbed at the heat absorption side. This allows for the requirements of the heat exchanger to be easily fulfilled by efficiently exchanging heat at the heat dissipation side.

The first fluid 12 and the second fluid 14 are not limited to an insulative liquid and may be an insulative gas (e.g., air) or a conductive liquid. When using a conductive liquid, an insulative coating must be applied to the surfaces of the electrodes 18 and 19 that contact the first fluid 12 and the second fluid 14.

The projections 21a do not have to be formed by extending parts of the electrical insulators 21 and may be formed by adhering discrete components to the electrical insulator 21. In this case, after connecting the electrodes 18 and 19 to the P type thermoelectric semiconductor elements 16 and the N type thermoelectric semiconductor elements 17, the projections 21a may be coupled to the electrical insulator 21 so as to intersect the electrodes 18 and 19. This allows for the arrangement of the projections 21a and the electrodes 18 and 19 in an intersecting state without any problems and thereby increases the degree of freedom for the locations of the projections 21a.

In the first fluid passage 13 and the second fluid passage 15, the first fluid 12 and the second fluid 14 do not have to flow in the same direction. The first fluid 12 in the first fluid passage 13 and the second fluid 14 in the second fluid passage 15 may flow in opposite directions (opposed flow).

In the third embodiment, the valleys and ridges on the heat dissipation side and heat absorption side of the thermoelectric module 11 are provided without arranging the end faces of the P type thermoelectric semiconductor elements 16 and N type thermoelectric semiconductor elements 17 on the same plane. Further, the end faces of the P type thermoelectric semiconductor elements 16 and N type thermoelectric semiconductor elements 17 are arranged in rows, the locations of which are alternately varied. However, the present invention is not limited to such a structure. For example, the locations of just one half of the end faces in each row may be alternately varied. Alternatively, the locations of every single end face or every two end faces may be alternately varied.

In the third embodiment, the electrical insulator 21 that couples the P type thermoelectric semiconductor elements 16 and the N type thermoelectric semiconductor elements 17 do not necessarily have to be formed at locations corresponding to the projections 23.

When arranging the valleys and ridges on the heat dissipation side and heat absorption side of the thermoelectric module 11 without arranging the end faces of the P type thermoelectric semiconductor elements 16 and N type thermoelectric semiconductor elements 17 on the same plane, P type thermoelectric semiconductor elements 16 of two different lengths and N type thermoelectric semiconductor elements 17 of two different lengths may be used.

The matrix array of the P type thermoelectric semiconductor elements 16 and the N type thermoelectric semiconductor elements 17 that form the thermoelectric module 11 do not have to include the same number of rows and columns.

The P type thermoelectric semiconductor elements 16 and the N type thermoelectric semiconductor elements 17 do not have to have the shape of a square pillar and may have the shape of another type of a polygonal pillar or a cylindrical pillar.

In addition to the fourth embodiment, the other embodiments may also include the packing 24 that is formed around the thermoelectric module 11 and attaches the thermoelectric module 11 between the first fluid passage 13 and the second fluid passage 15.

The present examples and embodiments are to be considered as illustrative and not restrictive, and the invention is not to be limited to the details given herein, but may be modified within the scope and equivalence of the appended claims.

A heat exchanger includes a thermoelectric module (11). A first fluid passage (13) is arranged at a heat dissipation side of the thermoelectric module (11) and a second fluid passage (15) is arranged at a heat absorption side of the thermoelectric module (11). The thermoelectric module (11) includes P type and N type thermoelectric semiconductor elements (16, 17). An electrical insulator (21) couples the P type and N type thermoelectric semiconductor elements (16, 17). Heat dissipation side electrodes (18) are exposed in the first fluid passage (13) and heat absorption side electrodes (19) are exposed in the second fluid passage (14). At least the heat dissipation side of the thermoelectric module (11) includes valleys and ridges with the heat dissipation side electrode (18) being free from projections.

## Claims

1. A heat exchanger **characterized by**:
a thermoelectric module (11), in which heat exchange is performed between a first fluid (12) flowing through a first fluid passage (13) arranged at a heat dissipation side of the thermoelectric module (11) and a second fluid (14) flowing through a second fluid passage (15) arranged at a heat absorption side of the thermoelectric module (11), the thermoelectric module (11) including:
a plurality of P type thermoelectric semiconductor elements (16) and a plurality of N type thermoelectric semiconductor elements (17) that are thermally arranged in parallel;
heat dissipation side electrodes (18) formed by planar plates and heat absorption side electrodes (19) formed by planar plates that electrically connect in series the P type thermoelectric semiconductor elements (18) and the N type thermoelectric semiconductor elements (19);
an electrical insulator (21) that couples the P type thermoelectric semiconductor elements (16) and the N type thermoelectric semiconductor elements (17) so as to impede fluid movement between the first fluid passage (13) and the second fluid passage (14);
wherein the heat dissipation side electrodes (18) are exposed in the first fluid passage (13) and the heat absorption side electrodes (19) are exposed in the second fluid passage (15); and
at least the heat dissipation side of the thermoelectric module (11) includes valleys and ridges with the heat dissipation side electrodes being free from projections.

2. The heat exchanger according to claim 1, wherein the valleys and ridges are formed by part of the electrical insulator (21a) projected into the first fluid passage (13) further from the heat dissipation side electrode (18).

3. The heat exchanger according to claim 2, the part of the electrical insulator (21) forms a plurality of flow paths (13b) in the first fluid passage (13).

4. The heat exchanger according to claim 2 or 3, wherein the part of the electrical insulator (21a) projected into the first fluid passage (13) is formed integrally with part of the electrical insulator (21) that couples the P type thermoelectric semiconductor elements (16) and the N type thermoelectric semiconductor elements (17).

5. The heat exchanger according to claim 2 or 3, wherein the part of the electrical insulator (21a) projected into the first fluid passage (13) is formed discretely from part of the electrical insulator (21) that couples the P type thermoelectric semiconductor elements (16) and the N type thermoelectric semiconductor elements (17) and adhered to said part.

6. The heat exchanger according to claim 1, wherein the valleys and ridges are formed by coupling the P type thermoelectric semiconductor elements (16) and the N type thermoelectric semiconductor elements (17) with the electrical insulator 21 so that end faces of the P type thermoelectric semiconductor elements (16) and N type thermoelectric semiconductor elements (17) are located on different planes.
